# EUROPEAN PATENT SPECIFICATION

(11) **EP 0 399 975 B1**
(45) Date of publication and mention of the grant of the patent: **02.11.1995**
(21) Application number: 90850190.1
(22) Date of filing: 18.05.1990
(51) Int. Cl.: H01Q 1/12, H03H 7/38

(54) **RF connector for the connection of a radiotelephone to an external antenna**
HF-Stecker zur Verbindung eines Radiotelefonapparates mit einer aussenliegenden Antenne
Connecteur HF pour connecter un radiotéléphone à une antenne externe

(30) Priority: 22.05.1989 FI 892480
(43) Date of publication of application: 28.11.1990
(73) Proprietor: NOKIA MOBILE PHONES LTD., 24101 Salo (FI)
(72) Inventor: Väisänen, Riso, SF-241 00 Salo (FI)
(74) Representative: Jörneld, Bo

(56) References cited:
- EP-A- 0 108 010
- US-A- 2 829 367
- US-A- 4 031 468
- US-A- 4 717 896
- US-A- 4 794 319
- WIRELESS WORLD, vol. 84, no. 1506, February 1978, pages 26-30, Haywards Heath,GB; J.R. SMITH: "A basic radio telescope"

## Description

The present invention concerns an RF connector for the connection of a mobile device, especially a radiotelephone to an external antenna, whereby the mobile device and correspondingly a device rack connected to the external antenna have two pairs of matching metal plates that provide a capacitive two-wire connector-interface.

Two antenna connectors are generally employed in radiotelephones, whereby one is connected to the antenna which is used when the telephone operates as a portable device while the other interface will be used when the radiotelephone is in a car. The car antenna is then switched into operation through the auxiliary antenna connector with the aid of an antenna change-over switch of the radiotelephone.

At present the most broadly employed connector types rely on a galvanic contact, whereby they i.a. exhibit the following disadvantages:
- the connector surfaces will get worn and corroded in course of time;
- the connectors will be easily damaged by mechanical stresses;
- the connectors are visible, and they can be concealed in the telephone body only by using e.g. a separate protecting lid.

Depending on the connector type there may exist further disadvantages:
- the connector must be exactly aligned when mounted into the rack in a car (e.g. a common coaxial connector);
- the connector occupies a large space inside the telephone (this is the case with most present connectors);
- the connector will easily get dirty (e.g. a coaxial connector);
- the price of the connector is high (specially made surface mount connectors).

Recently it was realized to employ a capacitive RF connector which consists of two pairs of metal plates. The pair of smaller metal plates constitutes the inner conductor of the RF interface for the coaxial cable and the pair of larger plates, of which the other plate is formed by the metallic body of the telephone (e.g. 6 x 18 cm), constitutes the interface for the sheath of the coaxial cable.

Because the earth conductor is disconnected with a capacitor, the capacitance of the capacitor must be high in order to achieve a low attenuation. In a known implementation this was then solved by utilizing the metallic body of the telephone. On the other hand, the capacitances of the inner conductor capacitors must also be relatively high, because the signal transmission is carried out at a relatively low impedance level (about 50 ohms).

It is known from US-A-2 829 367 to couple through a balanced signal by utilizing both capacitive and inductive coupling. The patent concerns a television lead-in coupler where the aim is to maintain efficient energy transfer over a wide frequency range.

Furthermore, it is known from US-A-4 794 319 to transfer a signal capacitively from a cable to an antenna. Since the antenna can be realized without earth, the signal can be balanced and there is no problems with the requirement of one pair of big size coupling plates (for the cable mantle or earth), as described above.

The present invention relates to a case where the signal is unbalanced and the big sizeplate pair would constitute a problem.

The invention overcomes this problem by providing balanced transformer and a resonant circuit with the help of the capacitor and a suitable coil connected in series with the two-plate capacitor. More precisely, the invention is characterized in that a coil is connected in series with the pair of plates constituting each capacitor so that the coil and the capacitor form a resonant circuit at the employed transmission frequency, the reactance of the coil being equal to the reactance value of the respective capacitor formed by the pair of plates, and that into the signal transmission path there is further introduced a first balancing transformer, which transforms the signal into a balanced signal before the resonant circuit, and a second balancing transformer, which transforms the signal back to an unbalanced signal after the resonant circuit.

Preferably the pairs of plates comprise four metal plates of the same size, and the plates on the portable device side are located under the plastic casing of the device.

The impedance values of the balancing transformers could be e.g. 50 ohm/200 ohm on the input side and e.g. 200 ohm/50 ohm on the output side of the resonant circuit.

The connector according to the invention is not easily damaged by mechanical stresses. It is possible to make it invisible and it will not get dirty, because the plates can be located under the plastic casing. The connector is cheap and in depth it will occupy only a small space. It will not present problems of alignment as the plates must not match very exactly in the lateral direction and in depth; in practice a precision of 20% will be sufficient.

The connector will present no problems of wear and also no contacting problems as there is no galvanic connection between the plates.

The attenuation of the connector is low, and it will operate as a filter attenuating harmonics of the transmitter and rejecting spurious responses of the receiver.

In a digital radiotelephone (e.g. is a GSM telephone) all of the connector can be made without any galvanic contact surfaces (except for the charging interface in the battery package) when the logic signals are interfaced with an optical interface and when the connector of the auxiliary RF antenna is connected with a capacitive connector.

The invention will be described further by way of an example referring to the accompanying drawing, where
- figure 1: shows the basic circuit arrangement of the RF connector according to the invention, and
- figure 2: shows a practical implementation of the connector circuit.

The connector comprises four metal plates 1a, 1b, 2a, 2b of the same size, two coils 3a and 3b, and two balancing elements 4 and 5, as will be described below.

The signal (RFin) of the coaxial cable is first transformed into a balanced signal through a balancing transformer 4 with an input impedance of 50 ohms and an output impedance of 200 ohms. After the balancing transformer the signal is connected to two metal plates 1a, 1b, which are located in the outer casing of the telephone 1, preferably protected under the plastic surface of the casing.

On the car rack side there are similar metal plates 2a, 2b, which are located in points corresponding to the plates 1a and 1b in the radiotelephone 1 when the telephone is mounted in the rack. Thereby the four plates constitute two capacitors, permitting the passage of an RF signal. The signal transmission would not be possible using only capacitors, however, because the impedance of the capacitors is too high and thus the attenuation would be very high. In order to obviate this problem a coil 3a, and 3b respectively, is introduced into the signal path in series with each capacitor, the reactance value of the coil being equal to the reactance value of the respective capacitor formed by the pair of plates. Thus the plates and the coils form series-resonant circuits with an impedance of nearly 0 ohm at the transmission frequency in question. After the resonant circuit the signal is transformed with a second balancing transformer 5 back to an unbalanced signal (RFout), which then can be transmitted to a car antenna through a coaxial cable.

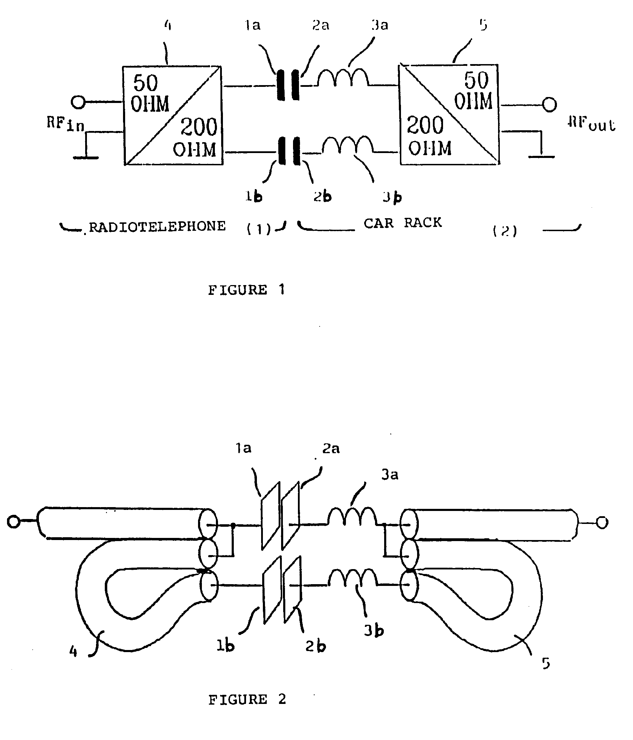

In figure 2 there is shown an embodiment of the connector according to the invention. The construction is very simple; short pieces of coaxial cable measuring a half wave in length are used as balancing transformers. The length of the cable piece is e.g. about 11,5 cm when the operating frequency is 900 MHz.

It will be appreciated that other designs may be applied within the limits of the inventive idea.

## Claims

1. RF connector for the connection of a mobile device, especially a radiotelephone (1) to an external antenna, whereby the mobile device and correspondingly a device rack (2) connected to the external antenna have two pairs of matching metal plates (1a, 2a, 1b, 2b) that provide a capacitive two-wire connector-interface, **characterized** in that a coil (3a, 3b) is connected in series with the pair of plates (1a, 2a, 1b, 2b) constituting each capacitor so that the coil and the capacitor (1a, 2a, 1b, 2b) form a resonant circuit at the employed transmission frequency, the reactance of the coil being equal to the reactance value of the respective capacitor formed by the pair of plates, and that into the signal transmission path there is further introduced a first balancing transformer (4), which transforms the signal into a balanced signal before the resonant circuit, and a second balancing transformer (5), which transforms the signal back to an unbalanced signal after the resonant circuit.

2. RF connector according to claim 1, **characterized** in that the pairs of plates (1a, 2a, 1b, 2b) comprise four metal plates of the same size.

3. RF connector according to claim 1 or 2, **characterized** in that the impedance values of the balancing transformers are 50 ohm/200 ohm on the input side and 200 ohm/50 ohm on the output side of the resonant circuit.

4. RF connector according to any of the preceding claims, **characterized** in that the metal plates (1a, 1b) on the portable device (1) side are located under the plastic casing of the device.

5. RF connector according to any of the preceding claims, **characterized** in that the balancing transformer (4, 5) on each side of the resonant circuit comprises a short piece of coaxial cable measuring a half wave in length.

## Patentansprüche

1. HF-Stecker zur Verbindung eines mobilen Gerätes, insbesondere eines Funktelefons (1), mit einer Außenantenne, wobei das mobile Gerät und dementsprechend ein an die Außenantenne angeschlossener Geräterahmen (2) zwei Paare von zueinander passenden Metallplatten (1a, 2a, 1b, 2b) aufweisen, die einen kapazitiven zweipoligen Verbindungsstecker bilden, dadurch gekennzeichnet, daß mit dem jeden Kondensator bildenden Plattenpaar (1a, 2a 1b, 2b) eine Spule (3a, 3b) in Serie geschaltet ist., so daß die Spule und der Kondensator (1a, 2a, 1b, 2b) bei der angewendeten Übertragungsfrequenz einen Schwingkreis bilden, wobei die Reaktanz der Spule dem Reaktanzwert des jeweils von dem Plattenpaar gebildeten Kondensators entspricht, und daß weiters in den Signalübetragungsweg ein erster Abgleichwandler (4), welcher das Signal vor dem Schwingkreis in ein abgeglichenes Signal umwandelt, sowie ein zweiter Abgleichwandler (5) zwischengeschaltet sind, welcher das Signal nach dem Schwingkreis in ein nicht abgeglichenes Signal rückwandelt.

2. HF-Stecker nach Patentanspruch 1, dadurch gekennzeichnet, daß die Plattenpaare (1a, 2a, 1b, 2b) vier Metallplatten gleicher Größe umfassen.

3. HF-Stecker nach Patentanspruch 1 oder 2, dadurch gekennzeichnet, daß die Impedanzwerte der Abgleichwandler an der Eingangsseite des Schwingkreises 50 Ohm/200 Ohm und an dessen Ausgangsseite 200 Ohm/50 Ohm betragen.

4. HF-Stecker nach einem der vorhergehenden Patentansprüche, dadurch gekennzeichnet, daß die Metallplatten (1a, 1b) aufder Seite des mobilen Gerätes (1) unter dem Kunststoffgehäuse des Gerätes angeordnet sind.

5. HF-Stecker nach einem der vorhergehenden Patentansprüche, dadurch gekennzeichnet, daß der Abgleichwandler (4, 5) aufjeder Seite des Schwingkreises ein kurzes Koaxialkabelstück umfaßt, dessen Länge einer halben Wellenlänge entspricht.

## Revendications

1. Connecteur à radiofréquences pour connecter un dispositif mobile, en particulier un radiotéléphone (1) à une antenne externe, le dispositif mobile et, de manière correspondante, un tiroir de ce dispositif (2) relié à l'antenne externe comportant deux paires de plaques métalliques correspondantes (1a, 2a, 1b, 2b) qui fournissent une interface de connecteur à deux fils capacitif, caractérisé en ce qu'une bobine (3a, 3b) est connectée en série avec la paire de plaques (1a, 2a, 1b, 2b) constituant chaque condensateur, de sorte que la bobine et le condensateur (1a, 2a, 1b, 2b) forment un circuit résonant à la fréquence de transmission employée, la réactance de la bobine étant égale à la valeur de réactance du condensateur respectif formé par la paire de plaques, et en ce que, sur la voie de transmission du signal, est de plus introduit un premier transformateur-égalisateur d'équilibrage (4) qui transforme le signal en un signal symétrique avant le circuit résonant, et un deuxième transformateur-égalisateur (5), qui transforme le signal pour le ramener à un signal asymétrique après le circuit résonant.

2. Connecteur à radiofréquences selon la revendication 1, caractérisé en ce que les paires de plaques (1a, 2a, 1b, 2b) comprennent quatre plaques métalliques de même dimension.

3. Connecteur à radiofréquences selon la revendication 1 ou 2, caractérisé en ce que les valeurs d'impédance des transformateurs-égalisateurs sont de 50 Ohm/200 Ohm du côté entrée et de 200 Ohm/50 Ohm du côté sortie du circuit résonant.

4. Connecteur à radiofréquences selon l'une quelconque des revendications précédentes, caractérisé en ce que les plaques métalliques (1a, 1b) du côté du dispositif portable (1) sont situées sous le boîtier en matière plastique du dispositif.

5. Connecteur à radiofréquences selon l'une quelconque des revendications précédentes, caractérisé en ce que le transformateur-égalisateur (4, 5) de chaque côté du circuit résonant comprend un court morceau de câble coaxial, mesurant une demi-onde en longueur.
